(19) **Europäisches Patentamt / European Patent Office / Office européen des brevets**

(11) **EP 3 454 390 A1**

(12) # EUROPEAN PATENT APPLICATION

(43) Date of publication:
**13.03.2019 Bulletin 2019/11**

(51) Int Cl.:
***H01L 51/52*** *(2006.01)*

(21) Application number: **18186388.7**

(22) Date of filing: **30.07.2018**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**KH MA MD TN** | (71) Applicant: **Barco N.V.**<br>**8500 Kortrijk (BE)**<br><br>(72) Inventors:<br>• **CHESTERMAN, Frédérique Stephen John**<br>**9050 Ledeberg (BE)**<br>• **VETSUYPENS, Arnout**<br>**B-8400 Oostende (BE)** |
| (30) Priority: **08.09.2017 GB 201714521** | (74) Representative: **IPLodge bvba**<br>**Technologielaan 9**<br>**3001 Heverlee (BE)** |

(54) **METHOD AND SYSTEM FOR REDUCING REFLECTION OF AMBIENT LIGHT IN AN EMISSIVE DISPLAY**

(57) An emissive display, for example Organic Light-Emitting Diode (OLED) display, a method of constructing and using and a method of operating such a display are described. A solution for reducing the reflection of ambient light is provided, which results in the lower light losses, e.g. lower losses than for conventional solutions. Because embodiments of the present invention provide a solution that can reduce the reflection of ambient light from a display having a reflective layer, this will in turn improve the display's contrast in the presence of ambient light.

Figure 13

**EP 3 454 390 A1**

**Description**

The present invention is situated in the field of emissive displays, for example fixed format displays such as Organic Light-Emitting Diode (OLED) displays, methods of constructing and using and methods of operating such displays.

**Background**

One of the major advantages of an OLED display compared to an LCD is its high contrast which results from the ability to display deep blacks. A drawback is that this contrast is reduced significantly in the presence of ambient light because of reflections from some of the emissive display's reflective internal components (e.g. the metallic electrode(s) and the metallic power lines).

A conventional method to cope with reflection of ambient light for emissive displays is placing a circular polarizer in front of the display (ref. US 7,259,505 B2; US 6,936,960 B2). A circular polarizer consists of a linear polarizer and a quarter wave plate. Incident ambient light first passes the linear polarizer which polarizes the light in one dimension. The light then passes through the quarter-wave plate, reflects off the reflective components in the display, and passes through the quarter-wave plate again to rotate the light in a dimension orthogonal to the linear polarizer so that the remainder of the reflected light is absorbed. About 99.5% of the ambient light that is reflected back through the circular polarizer is absorbed. However, also approximately 55% of the light that is used to display images and which passes once through the polarizer is absorbed. Hence, about 55% of the light emitted by the light source is lost.

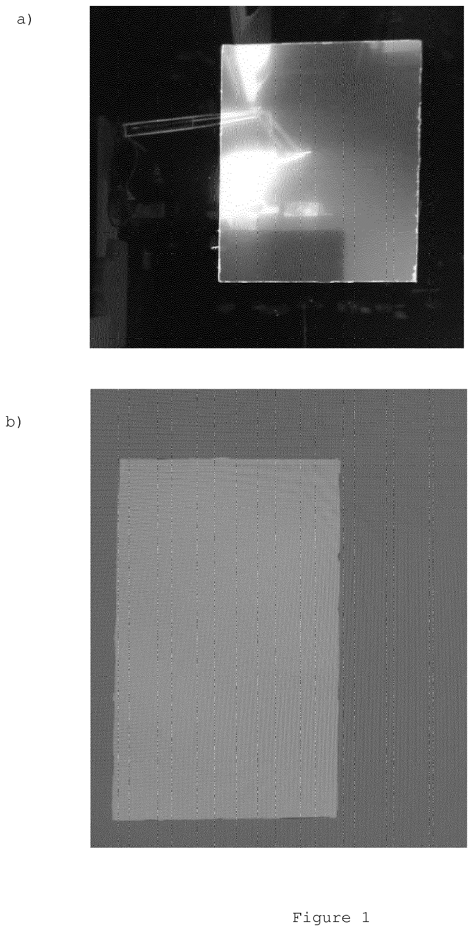

Figure 1a) shows an image of an OLED display with circular polarizer for which the polarizer has been removed in an inner rectangle of the display surface. The display is switched off and ambient light impinges on the display. It can be seen that the reflection of ambient light is much stronger on the display surface without any polarizer. Figure 1b) shows the same OLED display when it is switched on displaying a single colour. Also here it can be seen that the inner part without polarizer is much brighter.

Although a circular polarizer is an effective method for reducing ambient reflection, the display's maximum brightness (luminance) is reduced significantly. This also means that a much higher current needs to flow through the display emissive components in order to maintain an acceptable brightness. It is known that the lifetime of e.g. an OLED is inversely related to the current flowing through it; a higher current results in a shorter lifetime. An expression that is often used to approximate the relation between luminance and lifetime is $L_0^n t_{1/2} = \text{const}$, in which n = 1.7 - 2.6 is a typical range. This relation provides an estimate of the life time and indicates that in order to compensate for the losses of the circular polarizer (i.e. increasing the brightness of the OLED display by a factor of 2.2), the lifetime of the OLED display is decreased by a factor of 3.9 - 7.8.

Thus, this conventional solution of reducing the reflection of ambient light comes at a high cost.

Sometimes it's desirable to add external light when working on a display. Recently there have emerged lamps designed for e-reading, see for example http://the-gadgeteer.com/2016/12/21/benq-wit-e-reading-led-desk-lamp-review/. BenQ provides a WiT e-Reading LED desk lamp with a heavy pedestal base and an adjustable arm with two hinges that allow the head of the lamp to be as low as 30cm up to 85cm from the desk's top. The BenQ WiT lamp has two controls: a chrome ring on the end and a knob on top. The ring is a touch control that toggles power. The knob twists and can be pressed in. Pressing it toggles between brightness and color temperature modes. Twisting the knob adjusts the brightness level in brightness mode or changing the color temperature from cold to warm while in color temperature mode. If the ring is touched and held a green LED lights up and the lamp is in Eye-Care Mode which sets the brightness level based on the ambient light. There are white and yellow LEDs. Using the knob on the top of the lamp, the temperature color can be adjusted to customize the type of light. The illumination system can be brighter at the sides (up to 1800 LUX), and darker in the middle to reduce screen glare. There are certain applications within the field of healthcare where a darker environment is needed but the user should still be able to read e.g. a paper document when sitting next to the display. These displays are therefore often equipped with an external light source. If an emissive display having a reflective layer is used, the added light will reflect from the reflective layer and there will be a decrease in contrast of the displayed content.

US9142803 discloses a display having an absorption filter that has negative correlation with an outgoing spectrum of the display. However, the solution does not consider that when external light of wavelengths in the filters passband impinges onto the display, it will not be absorbed but be reflected which will result in a decreased contrast.

**Summary**

It is an objective of the present invention to provide a fixed format display such as an Organic Light-Emitting Diode (OLED) display, a method of constructing and using and a method of operating such a display with lower light losses.

Embodiments of the present invention provide a solution for reducing the reflection of ambient light, which results in the lower light losses, e.g. lower losses than for conventional solutions. Because embodiments of the present invention provide a solution that can reduce the reflection of ambient light from a display having a reflective layer, this will in turn improve the display's contrast in the presence of ambient light.

Although embodiments of the present invention are described with reference to OLED displays, the present invention is not limited thereto but can also be used for other types of displays such as fixed format displays for which the emission has narrow spectral bands and where reflective components in the display cause reflections of ambient light especially if they are causing unacceptable reflections of ambient light. For example, in QLED (Quantum dot Light Emitting Diodes) display technology, the light emission is originating from quantum dot materials which are typically even more narrowband than OLEDs. Another example is the micro-LED technology in which light emission originates from inorganic LEDs.

It is an objective of embodiments of the present invention to provide a display system comprising a display with internal emissive light sources and a layer for light absorption and an external light source. The internal light sources provide internal light with spectral emission bands, and one or more external light sources provide external light of at least one spectral emission band, and the absorption layer has at least one spectral absorption band and at least one spectral transmission band. The one or more external light sources contribute to ambient light for the display. The one or more external light sources can be selected so that the wavelength range defined by the full width half maximum of each of the external spectral emission bands has no overlap with the wavelength range defined by the full width half maximum of any of the spectral emission bands of the internal light sources. And the absorption layer is preferably selected such that each of the external spectral emission bands is overlapped by an absorption band of the absorption layer such that the absorption of the external light is at least 50%, and the spectral emission bands of the internal light sources are overlapped by a spectral transmission band of the absorption layer such that the transmission of each of the internal light is at least 45%.

This has the advantage of being able to use an external light source for ambient lighting (e.g. for reading a paper document next to the display) but reflections in the display from the external light source can be reduced by the absorbing layer and hence preserve the contrast of the outputted content. The fraction of the internal light emitted by the display and then absorbed, is much lower than with conventional anti-reflection solutions.

The absorption layer can be selected such that each of the at least one spectral emission bands of the external light is overlapped by a spectral absorption band of the absorption layer such that the absorption of the external light is at least 60, 70% or is up to 80% or equivalent.

The spectral emission bands of the internal light sources can be overlapped by a spectral transmission band of the absorption layer such that the transmission of each of the internal light is at least 55, or 65% or up to 75% or equivalent.

Additionally or alternatively, the contribution of each of a multiple of external light sources can be adapted so that all of the light sources together provide white light. A combination of coloured light can create white light. Points of white light are defined by different colour temperatures distributed along the Planckian locus. Hence in the present invention "white light" can be created when the emission peaks of several light sources combine into colour points along the Planckian locus, or the Daylight locus (see for example *Topics in applied physics 133, III-Nitride Based Light Emitting Diodes and Applications, chapter 13.2.1).* There can be an acceptable deviation from the Planckian locus of □xy (□xy = sqrt((□x)$^2$+(□y)$^2$). This deviation can be 0,1 or 0,05 or 0,005. Within such a deviation it is assumed that the light would be considered to be white, i.e. is perceived by the human eye as being white.

This has the advantage of providing reading comfort to the user without having to be restricted to unusual colors of the reading light.

Additionally or alternatively, the display can have an anti-reflective coating which can be configured to reduce reflection in the spectral emission bands of the external light.

This is advantageous since there is a trade-off between wavelength range and reduction in reflection in the design of an anti-reflective coating. By having to consider less amounts of wavelengths, the reflection can be further reduced.

Additionally or alternatively the display can have an anti-reflective coating which is configured to enhance transmission in the spectral emission bands of the internal light.

This has the advantage of increasing the transmission of internal light.

Additionally or alternatively, the display system can have a light scattering layer positioned to receive internal light transmitted by the absorption layer.

This has the advantage of smearing out the impact of non-uniform absorption in the absorption layer on the internal light. By placing a light scattering layer after the absorption layer, angular variation can be averaged out.

Additionally or alternatively, the energy of the internal light in each of the wavelength ranges 440 nm - 481 nm, 503 nm - 569 nm and 588 nm - 664 nm, and the energy of the external light in one or both of the wavelength ranges 570 nm - 587 nm and 482 nm - 502 nm, can be up to 80 % or more of the total energy of the light.

This has the advantage of providing a good contribution of internal and external light, with the external emission bands being positioned between the internal emission bands.

Additionally or alternatively, the display system can have a first, second and third internal light source, and a light absorption layer, whereby the intensities of the first, second and third internal light sources are tuned such that the light transmitted by the absorption layer is white light. A combination of coloured light can create white light. Points of white light are defined by different colour temperatures distributed along the Planckian locus. Hence in the present invention "white light" can be created when the emission peaks of several light sources combine into colour points along the Planckian locus, or the Daylight locus (see for example *Topics in applied physics 133, III-Nitride Based Light Emitting Diodes and Applications, chapter 13.2.1)*. There can be an acceptable deviation from the Planckian locus of $\square xy$ ($\square xy$ = sqrt(($\square x)^2$+ ($\square y)^2$). This deviation can be 0,1 or 0,05 or 0,005. Within such a deviation it is assumed that the light would be considered to be white, i.e. is perceived by the human eye as being white.

Additionally or alternatively, the absorption of the absorbing layer in the wavelength range 482 nm - 502 nm or 570 nm - 587 nm is such that at least 80% of the external light is absorbed.

This has the advantage of having a large part of the absorption bands overlapping the external light resulting in efficient reduction of the reflection.

Additionally or alternatively, the transmission of the absorption layer in wavelength ranges 440-481, 503-569 and 588-664 is such that at least 50% of the internal light is transmitted.

This has the advantage of having the absorption layer allowing most of the internal light passing through and allowing a low level of absorption where the internal emission is normally very high.

Additionally or alternatively, the external light source can be embedded on the front side and/or back side of the display housing, or placed separately from the display housing.

This has the advantage of having several options for the placement of the external light.

Additionally or alternatively, the layer for light absorption can be positioned in between the internal light sources of the display and the front glass of the display. Additionally, the layer for light absorption can also serve as a bonding layer for bonding the front glass to the display.

In another embodiment of the present invention there is provided a method for reducing the reflection of external light in a display system comprising a display with internal emissive light sources and a layer for light absorption and at least one external light source. The internal and at least one external light source provide light that has spectral emission bands and the absorption layer has spectral absorption bands and spectral transmission bands. The method can comprise the steps of selecting the external light source so that the wavelength range within the full width half maximum of each of the external spectral emission bands are not overlapping the wavelength range within the full width half maximum of any of the spectral emission bands of the internal light sources. It can further comprise selecting the absorption layer so that each of the at least one spectral emission band of the external light can be overlapped by a spectral absorption band of the absorption layer such that the absorption of the external light is at least 50%,60%, 70% or up to 80% or equivalent, and the spectral emission bands of the internal light sources can be overlapped by a spectral transmission band of the absorption layer such that the transmission of the light of each of the internal light sources is at least 45%; or 55% or 65% or up to 75% or equivalent.

This has the advantage of allowing use of an external light source (e.g. for reading a paper document next to the display) but reflections in the display from the external light source can be reduced by the absorbing layer and hence preserve the contrast of the outputted content.

In another aspect the present invention further provides a method for reducing the reflection of external light in a display system, the method comprising the steps of

- providing a display with internal emissive light sources and an absorption layer, wherein internal light from the internal emissive light sources has spectral emission bands and the absorption layer has at least one spectral absorption band and at least one spectral transmission band,
- providing at least one external light source, wherein the external light from the at least one external light source has at least one external spectral emission band,

characterized in that

- the external light source is selected so that the wavelength range within the full width half maximum of each of the at least one external spectral emission band has no overlap with the wavelength range within the full width half maximum of any of the spectral emission bands of the internal light, and
- the absorption layer is selected and positioned such that each of the at least one external spectral emission band of the external light is overlapped by a spectral absorption band of the absorption layer such that the absorption of the external light is at least 50%, and
- the spectral emission bands of the internal light sources are overlapped by a spectral transmission band of the absorption layer such that the transmission of the light of each of the internal light sources is at least 45%.

Advantageously, the present invention also pertains to a method for adjusting a color point shift of initial color points of internal light sources in a display system as described above, the method comprising the step of reducing the DDLs of the internal light sources having color points in a color space such that the initial color points of the combined light are preserved in the color space and the driving level of any light source is 255 or less.

Advantageously, the present invention also pertains to a light absorption layer for use with a display comprising internal emissive light sources and with at least one external light source, wherein the internal light from the internal emissive light sources has spectral emission bands and wherein the light absorption layer has at least one spectral absorption band and at least one spectral transmission band, and wherein the external light from the at least one external light source has at least one external spectral emission band, the external light source being selected such that the wavelength range within the full width half maximum of each of the at least one external spectral emission band has no overlap with the wavelength range within the full width half maximum of any of the spectral emission bands of the internal light,

characterized in that the absorption layer is selected and is configured to be positioned such that each of the at least one external spectral emission band of the external light is overlapped by a spectral absorption band of the absorption layer such that the absorption of the external light is at least 50%, and wherein the spectral emission bands of the internal light sources are overlapped by a spectral transmission band of the absorption layer such that the transmission of the light of each of the internal light sources is at least 45%.

**Brief description of drawings**

The following description of the figures of specific embodiments of the invention is merely exemplary in nature and is not intended to limit the present teachings, their application or uses. Throughout the drawings, corresponding reference numerals indicate like or corresponding parts and features.

Figure 1 shows an emissive display with a reflective back plane, with and without a circular polarizer.
Figure 2 shows an embodiment of the present invention comprising the spectral bands of light from internal and external light sources.
Figure 3 shows the CIE colour space with a white point, display color point and ambient light color points and the Planckian locus.
Figure 4 shows a cross section of an embodiment of the present invention.
Figure 5 shows the emission bands of side-by-side RGB light sources.
Figure 6 shows the emission bands of WRGB OLED light sources.
Figure 7 shows the spectral sensitivity of the human eye.
Figure 8 shows the emission spectra of an amber LED.
Figure 9 shows the CIE 1935 colour space with colour points for cyan and amber LEDs.
Figure 10 shows absorption spectra of absorbing dyes.
Figure 11 shows emission and absorption spectra for an embodiment of the present invention.
Figure 12 shows emission and absorption spectra for an embodiment of the present invention.
Figure 13 shows a device of an embodiment of the present invention.
Figure 14 shows a device of an embodiment of the present invention.

**Definitions**

"Full Width at Half Maximum" (FWHM) will in this text be referred to as a length measure of a function, being the distance between points of the functions independent variable at which the function reaches half its maximum value. If the independent variables express wavelengths, there can be defined a wavelength range within the FWHM.

"Ambient light" is defined as all artificial light present in the room in which the display is operating and that does not originate from the internal light sources of the display directly. Light which exits a display can be reflected from walls and hence contribute to ambient light but this contribution is typically very small. Light from "external light sources" are light sources which contribute to the ambient light, i.e. are not internal light sources.

"Spectral emission band" is defined as a limited range of wavelengths within the visible spectrum for which the light emission is substantially higher than for other wavelengths within the visible spectrum.

"Binning" is a way to group a collection of values into groups or "bins". A representative value can be chosen for each bin, for example the average value. Calculations can then be performed per bin, using the representative value instead of using the individual values.

**Detailed description of illustrative embodiments**

The present invention will be described with respect to particular embodiments but the invention is not limited thereto but only by the claims. Any reference signs in the claims shall not be construed as limiting the scope.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

Furthermore, the terms first, second, third and the like in the description and in the claims, are used for distinguishing between similar elements and not necessarily for describing a sequential or chronological order, unless specified. It is to be understood that the terms so used are interchangeable under appropriate circumstances and that the embodiments of the invention described herein are capable of operation in other sequences than described or illustrated herein. The terms or definitions used herein are provided solely to aid in the understanding of the invention.

The terms "about" or "approximate" and the like are synonymous and are used to indicate that the value modified by the term has an understood range associated with it, where the range can be +20%, +15%, +10%, +5%, or +1%. The term "substantially" is used to indicate that a result (e.g., measurement value) is close to a targeted value, where close can mean, for example, the result is within 80% of the value, within 90% of the value, within 95% of the value, or within 99% of the value.

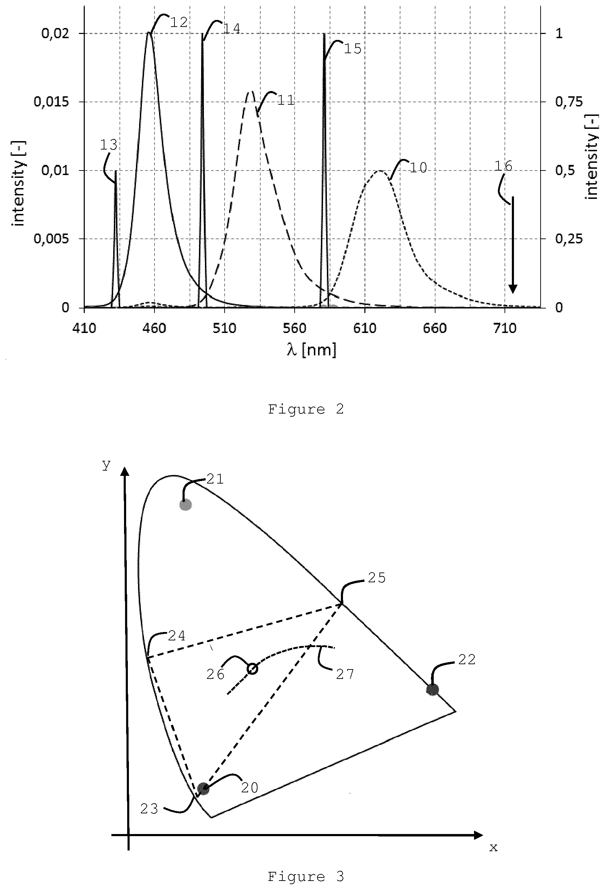

Figure 2 shows an embodiment of the present invention comprising the spectral peaks of the three red 10, green 11 and blue 12 internal light sources in an emissive display. These peaks can be relatively narrow, leaving regions between them in which the emission is low. Embodiments of the present invention work with an external light source or comprise adding an external light source for ambient illumination which is designed with spectral components located mainly or entirely in these low-emission regions. An absorber can be added in the optical path of the emissive elements, having absorbing bands in the same region as the external light source is emitting. Hence, the absorbing layer can reduce the emitted light in these regions without significantly absorbing the light of the display emitters. In this way the broadening of the display's spectral emission bands, resulting from the added reflected light, can be kept very low so that good contrast of the image content can be conserved. Ambient light impinging on the emissive display and reflecting from its metallic components passes the absorbing layer twice and is therefore efficiently reduced. Figure 2 also shows an example of the spectrum of an external light source with peaks 13, 14 and 15. The absorbing layer (not shown in figure 2) would ideally have absorption peaks overlapping the peaks 13, 14 and 15, and only to a limited extent overlap with the spectral bands 10, 11 and 12 of the display.

In a practical implementation there will however be an overlap present between the spectral bands of the different display emitters. The emission peak of the external light source and the absorption peak of the absorber can also not be made infinitely narrow, but the inventor has found that good results still can be achieved.

In figure 2 there can be four possible wavelength regions where the external light source can be positioned: At the peaks 13, 14 and 15 and at the arrow 16, which corresponds to deep blue, cyan, amber and far red, respectively. The external light source can emit in one or more wavelength bands resulting in a specific color. Combining two, three or four external light sources allows realizing different colours. For example, the hypothetic external light source shown in figure 2 will be perceived as white. Figure 3 shows the CIE 1931 color space with the red 20 green 21 and blue 22 primary fields. The peaks 13, 14 and 15 in figure 2 corresponds to points 23, 24 and 25 respectively. These colours can create the white point 26 (of approximately 6500 K). White points of different colour temperatures are distributed along the Planckian locus 27. A combination of coloured light can create white light. Points of white light are defined by different colour temperatures distributed along the Planckian locus. Hence in the present invention "white light" can be created when the emission peaks of several light sources combine into colour points along the Planckian locus, or the Daylight locus (see for example *Topics in applied physics 133, III-Nitride Based Light Emitting Diodes and Applications, chapter 13.2.1).* There can be an acceptable deviation from the Planckian locus of $\Box xy$ ($\Box xy = sqrt( (\Box_X)^2 + (\Box y)^2)$. This deviation can be 0,1 or 0,05 or 0,005. Within such a deviation it is assumed that the light would be considered to be white, i.e. is perceived by the human eye as being white.

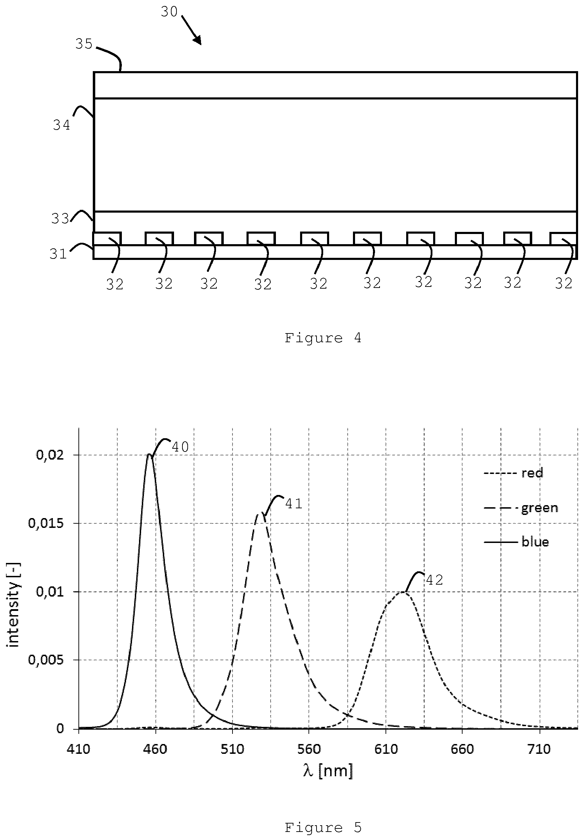

Figure 4 shows a cross section of a fixed format device e.g. an OLED device comprising an embodiment of the present invention. The OLEDs 32 are mounted onto a substrate 31 and embedded in a bonding layer 33 which connects to a glass plate 34. An absorbing material 35 could be added on top of the front glass 34 as an external film or coating. Alternatively or additionally, the absorbing material 35 could be added to or combined with the bonding layer 33.

The embodiment uses an external light source. In a healthcare context, the external light source can be placed apart from the display and can be used with or can replace the general lighting in the room in which the fixed format display, e.g. OLED display is used. Alternatively or additionally the external light source can be an ambient light source which can be integrated into the display housing. For example it can be placed at the bottom of the display for lighting a field near the display, such as the desk. Or the external light source can be placed at the back of the display, pointing at the wall, with the aim of providing general lighting in the room.

Embodiments of the present invention can be implemented using e.g. different types of fixed format display technology such as OLED display technology, of which side-by-side RGB OLED and WRGB OLED are two examples. The side-by-side RGB OLED display technology is for example implemented in the Samsung Note III, whereby each pixel comprises a red, green and blue sub-pixel. Figure 5 shows the spectral emission bands of these sub-pixels. The bands are narrow and there's limited spectral overlap between the emission of the red, green and blue sub-pixel.

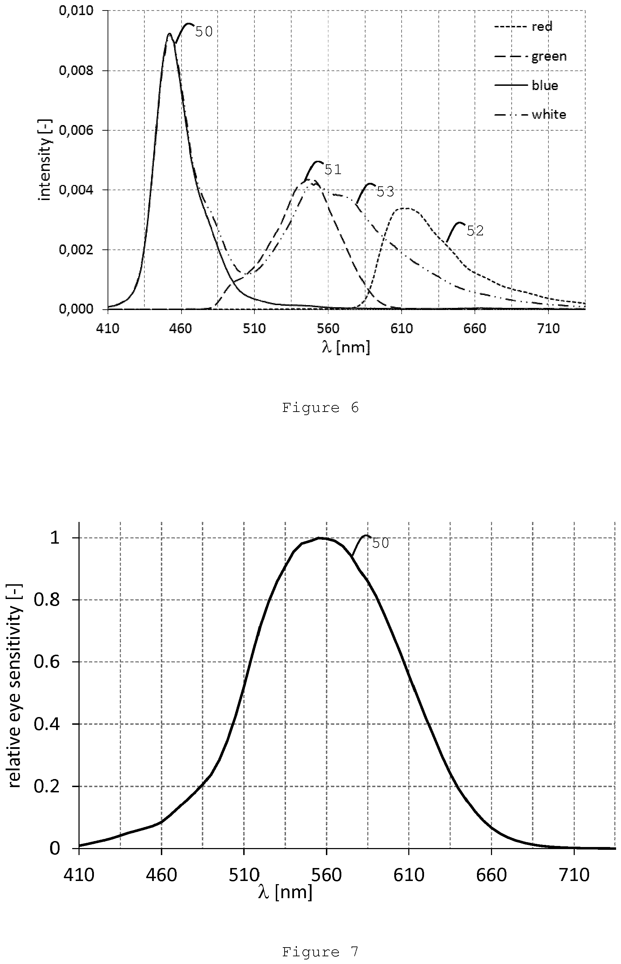

The WRGB (White Red Green Blue) OLED display technology is for example implemented in e.g. the LG® OLED55B6V™ TV. In a WRGB OLED display, each pixel comprises a white, red, green and blue sub-pixel. Each pixel produces the same white light but color filters are added to convert the white light into colored light for the red, green and blue sub-pixel. The OLED producing the white light is composed of an organic layer emitting in the blue region and an organic layer emitting in the yellow region. Figure 6 shows the spectrum of such a WRGB OLED display for the blue sub-pixel 50, green sub-pixel 51, red sub-pixel 52 and white sub-pixel 53. The light of the white sub-pixel is composed of a relatively narrow blue peak and a broader yellow peak. Thus, the addition of the narrowband absorber has relatively small impact on the emission for the red, green and blue sub-pixel, but a large portion of the light emitted by the white sub-pixel is absorbed.

Yet, it is expected that fixed format displays such as future OLED displays will move away from broadband light emission since this does not allow for a large color gamut. For example, the spectral shape of the white OLED in a WRGB OLED display could be composed of a red, a green and blue peak instead of a blue and a yellow peak.

*Further Exemplary embodiments*

The spectral emission bands of the red, green and blue light of a typical OLED are shown in figure 5. Suitable wavelength regions or ranges for additional ambient light can be deep blue (<437nm), cyan (488nm - 500nm), amber (576nm - 585nm) or far red (>675nm) . To choose which colours to select, the spectral sensitivity of the human eye can be considered, see figure 7. The maximum sensitivity 50 is around the wavelength of 556nm. The relative human eye sensitivity in the deep blue (<437nm), cyan (494nm), amber (581nm) and far red (>675nm) is respectively 4.5%, 27.6%, 88.9% and 2,6%. This means that an amber external light source will appear bright to a human, and a deep blue light source and a far red light source will hardly be visible, and a cyan light source will appear moderately bright. The light sources that are less visible are also often difficult to obtain. Therefore it could be advantageous to consider amber and cyan external light sources for the display in question.

Different types of light sources can be considered, for example LEDs (Light Emitting Diodes). LEDs can have relatively narrow spectral emission spectra, and they exist for a variety of peak emission wavelengths and are widely available.

Here follows examples of a number of LEDs that can emit in the above mentioned cyan and amber wavelength band regions. Products from the manufacturers OSRAM® (http://www.osram.nl/osram_ bx/nl/) and Lumiled® (http://www.lumileds.com/) are shown.

*Amber*

An example of an amber LED that can be used as part of the proposed solution is the OSRAM OSLON SSL 80: LY CP7P. This is an LED with a spectral emission band having a bandwidth of 15nm, a dominant wavelength at 590nm and a peak wavelength at 593nm. There is some variation in the dominant wavelength from one LED to another and binning is used for grouping the LEDs accordingly (Table 1).

Table 1: Binning according to the dominant wavelength for an amber LED (OSRAM OSLON SSL 80)

| Group | Min | Max |
|---|---|---|
| 3 | 583 | 586 |
| 4 | 586 | 589 |
| 5 | 589 | 592 |
| 6 | 592 | 595 |

Although the middle of the spectral emission wavelength band (in amber) with low spectral emission of the OLEDs is at 581nm, a peak wavelength of 585 nm can be more suited for this application as the peak absorption of the proposed absorbing dye (see further on) is at 585 nm. The peak wavelength is approximately 3 nm larger than the dominant wavelength, so a dominant wavelength of 582 nm is what is needed. The best matching bin is bin 3.

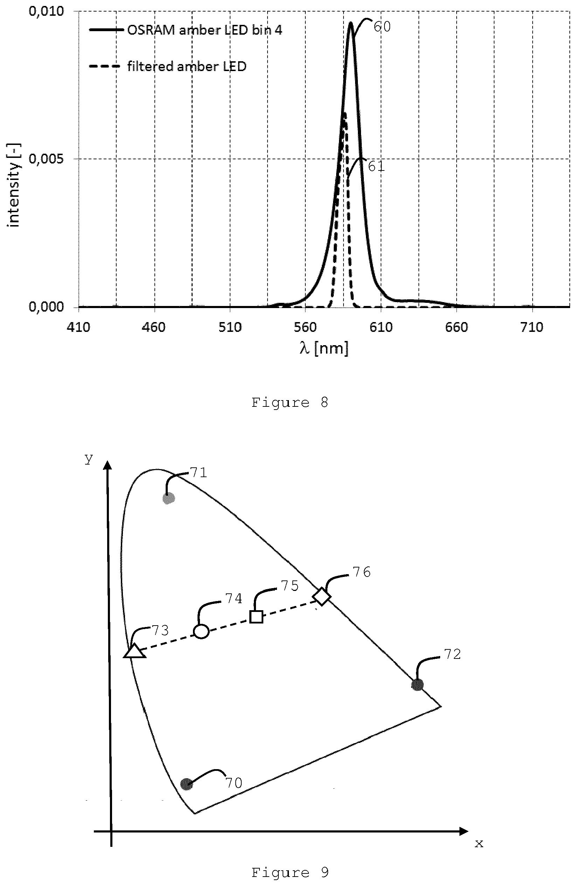

The peak wavelength for bin 4 is at approximately 590 nm which is too long. An interference filter with a centre wavelength of 585 nm is used to shift the emission of the LED to lower wavelength. The peak wavelength of the resulting transmitted LED light is now at 585 nm. Because of the mismatch between the emission of the bin 4 LED and the interference filter, a significant portion of the LED light is lost. Using a bin 3 LED would significantly improve this. The spectral emission of the amber LED (OSRAM OSLON SSL 80: LY CP7P) is shown in figure 8, before filtering 60 and after filtering 61 with the interference filter.

*Cyan*

A cyan LED that could be used for this application is the LUMILEDS LUXEON Rebel Color Line LXML-PE01 (LXML-PE01-0080 LXML-PE01-0070 LXML-PE01-0060 (which can be found in the DS68 LUXEON Rebel Color Line Product Datasheet 20171106 ©2017 Lumileds Holding B.V). The LUXEON Rebel Color Line has color stability, flux density and clear saturated colors, see (http://www.lumileds.com/products/color-leds/luxeon-rebel-color). This LED has a spectral emission band having a dominant wavelength in the wavelength range of 490 nm to 515 nm and 60 to 83 LUMINOUS FLUX (LM) OR RADIOMETRIC POWER (MW)at test current of 350 mamp. A LED with peak wavelength around 494 nm is useful which can be achieved through binning (bin 1 or bin 2).

Table 2: Binning according to the dominant wavelength for a cyan LED (LUMILEDS LUXEON Rebel Color Line LXML-PE01).

| Bin | Min | Max |
|-----|-----|-----|
| 1 | 490 | 495 |
| 2 | 495 | 500 |
| 3 | 500 | 505 |
| 4 | 505 | 510 |
| 5 | 510 | 515 |

The spectral bandwidth of this LED is 30 nm which is rather broad. An interference filter can be used to narrow down the width of the spectral emission peak.

*White light*

Figure 9 shows the CIE 1935 colour space with the colour points for filtered amber LED 76, the filtered cyan LED 73, the selected white light, obtained by combining the amber LED 76 and the cyan LED 73, and of the reflected light 74 when the selected white light 75 is incident on an OLED display with an absorbing layer.

Absorbers suitable for the present invention should preferably have narrow absorption bands with high transmission in the passband. Exciton® (http://www.exciton.com/) and Epolin® (http://www.epolin.com/) manufactures absorbing dyes that can be used in the amber and cyan regions.

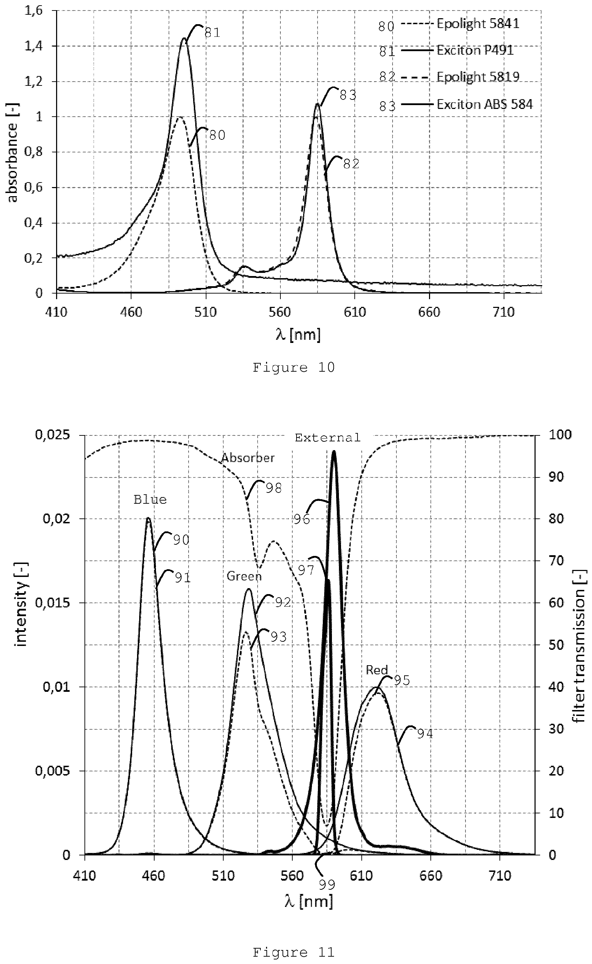

Some examples are shown in figure 10:

- Exciton ABS 584 83, has Peak Wavelength 583 ± 2 nm (methylene chloride), Strength 190 L/gm-cm (methylene chloride) Reddish purple powder, Melting Point > 300 °C, Spectral Purity Full width at half maximum in absorbance: 18.5 ± 2.0nm (methylene chloride)
- Exciton P491 81, Peak Wavelength 492 ± 1 nm (methylene chloride); 496 ± 1 nm (polycarbonate) Strength > 285 L/gm-cm (methylene chloride), Dark green powder Melting Point >210 °C.
- Epolin Epolight™ 5819 82, Absorption maximum, lambda max: 584 nm Absorptivity in chloroform: 190 L g-1 cm-1 Appearance: Red violet powder Melting point: > 300 °C

and

- Epolin Epolight™ 5841 80. Absorption maximum, λ max: 493 nm in chloroform; 498 nm in polycarbonate Absorptivity in chloroform: 359 L g$^{-1}$ cm$^{-1}$ Appearance: Red powder

For cyan:

- Exciton P491 81: http://www.exciton.com/pdfs/P491-0713.pdf see above
- Epolin Epolight™ 5841 80: http://www.epolin.com/product/5841.
  Absorption maximum, λ max: 493 nm in chloroform; 498 nm in polycarbonate Absorptivity in chloroform: 359 L g$^{-1}$ cm$^{-1}$ Appearance: Red powder.

Both Exciton and Epolin offer an absorbing dye having spectral absorption bands comprising a peak absorption in the cyan region of the visible spectrum. The peak wavelength and spectral width of the emission is approximately the same for both dyes. However, the spectral transmission in the passband is significantly higher for Epolin Epolight™ 5841 80 than for Exciton P491 81, which is important because, preferably as much of the light of the OLED display is transmitted. Therefore, Epolin Epolight 5841 80 is the preferred dye for this application.

For amber:

- Exciton ABS 584 83: http://www.exciton.com/pdfs/ABS584-072413.pdf Peak Wavelength 583 ± 2 nm (methylene chloride) Strength 190 L/gm-cm (methylene chloride) Appearance Reddish purple powder Spectral Purity Full width at half maximum in absorbance: 18.5 ± 2.0nm (methylene chloride) Melting Point > 300 °C

- Epolin Epolight 5819 82: http://www.epolin.com/product/5819 See above
  Both Exciton and Epolin offer an absorbing dye with peak absorption in the amber region of the visible spectrum. The spectral shape of both dyes is almost exactly the same. The spectral width in amber is narrow but there is a second absorption peak in green which is unwanted.

*Calculations*

Based on the data of the above materials selection, calculations were performed.

a) The absorption values of embodiments of the present invention were calculated and compared to calculations of implementations using a conventional circular polarizer. It was found that the absorption for the proposed solution of embodiments of the present invention is lower than for the circular polarizer. The differences achieved depended on the type of display and the type of narrowband absorber(s) used.
b) The amount of ambient reflection for embodiments of the present invention was calculated. It was shown that the narrowband absorption filter effectively absorbs the narrowband ambient light which leads to a low reflection. The exact amount of reflection depends on the spectral emission of the external light source and the spectral absorption of the filter.

Calculations were performed for both RGB OLED technology and for WRGB OLED technology. For each technology, an amber light source and a white light source was used. For the white light source, the gain in light output is calculated for absorbers from two different manufacturers: Exciton® and Epolin®.
Figure 11 shows exemplary spectral emission and spectral absorption spectra of an embodiment of the present invention. A side-by-side RGB OLED display is used for providing internal light. The OLED display sub-pixels have internal light with emission peaks and absorbed emission peaks in blue 90/91, green 92/93 and red 94/95, respectively. There is the added external emission peak 96 and the filtered external emission peak 97 and the filtered absorbed external emission 99, which is almost not distinguishable from the x-axis in the present scale. The absorber has an absorption peak 98 showing a good overlap with the external emission. For embodiments using other material choices there can be a multiple of ambient emission peaks and a corresponding multiple of absorption peaks.

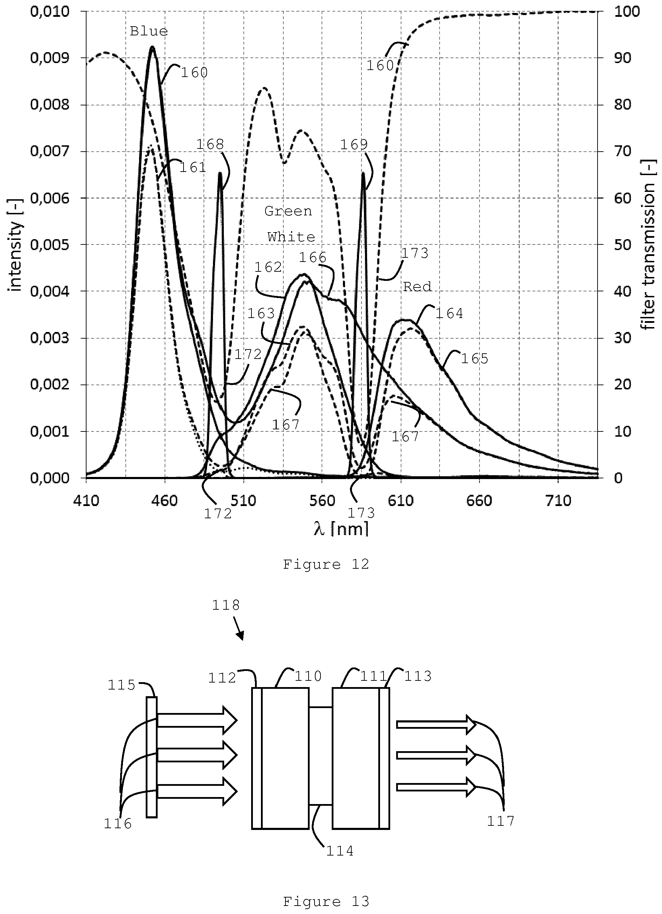

Figure 12 shows exemplary spectral emission and spectral absorption spectra of an embodiment of the present invention. A WRGB OLED display is used for providing internal light. The OLED sub-pixels have emission peaks and absorbed emission peaks in blue 160/161, green 162/163, red 164/165 and white 166/167, respectively. There are two filtered external emission peak 168 and 169 and the filtered absorbed external emission peaks 170 and 171, the former being visible- and the latter not visible in the present scale. The absorber has absorption peaks 172 and 173 exhibiting good overlap with emission peaks 168 and 169 respectively. (Note,that the invention is not limited to that a WRGB LED must be combined with more than one external emission band.)
Here follows calculations when absorbing dyes from Exciton are used. Table 3 shows the portion of ambient light impinging on an OLED display that is reflected when the absorbing layer is used, assuming the emissive display is 100% reflective.

Table 3: Calculated reflectance of ambient light when an amber light source and an amber + cyan light source is incident on an OLED display with absorbing layer.

| Reflection | Radiance | Luminance |
|---|---|---|
| amber + cyan | 2,1% | 1,5% |
| amber | 1% | 1% |

Result 1

*Absorbing dye from Exciton*

*Amber* external *light source + RGB OLED display*

The numerical values corresponding to figure 10 are listed in Table 4. The proposed solution allows for an increase in luminance for white of 73% compared to the circular polarizer.

Table 4: Calculations for a RGB OLED display, using an amber external light source and an absorbing dye fabricated by Exciton.

|  | R | G | B | W | W (L) |
|---|---|---|---|---|---|
| Polarizer transmission | 0.45 | 0.45 | 0.45 | 0.45 | 0.45 |
| Absorption filter transmission | 0.89 | 0.77 | 0.98 | 0.87 | 0.78 |
| Transmission ratio | +97% | 71% | +118% | +94% | +73% |
| Lifetime increase | 5.9 | 4.0 | 7.6 |  |  |

Result 2

*Absorbing dye from Exciton*

*Amber* external *light source + WRGB OLED display*

Table 5: Calculations for a WRGB OLED display, an amber external light source, and an absorbing dye fabricated by Exciton.

|  |  | R | G | B | W | W (L) |
|---|---|---|---|---|---|---|
| Polarizer transmission | Polarizer | 0.45 | 0.45 | 0.45 | 0.45 | 0.45 |
| Absorption filter transmission | Amber filter | 0.88 | 0.71 | 0.98 | 0.82 | 0.67 |
| Transmission ratio | L Increase | +96% | +58% | +117% | +82% | +47% |
| Lifetime increase | Lifetime increase | 5.8 | 3.3 | 7.5 | 4.7 |  |

Result 3

*Absorbing dye from Exciton*

White external *light source + side-by-side RGB OLED display*

The numerical values are listed in Table 6. The proposed solution allows for an increase in luminance for white of 48% compared to the circular polarizer.

Table 6: Calculations for a RGB OLED display, a white external light source, and absorbing dyes fabricated by Exciton.

| WRGB OLED display | | | | | | |
|---|---|---|---|---|---|---|
| | | R | G | B | W | W (L) |
| Polarizer transmission | Polarizer | 0.45 | 0.45 | 0.45 | 0.45 | 0.45 |
| Absorption filter transmission | Amber and cyan filter | 0.82 | 0.63 | 0.59 | 0.69 | 0.66 |
| Transmission ratio | L Increase | +83% | +40% | +32% | +53% | +48% |
| Lifetime increase | Lifetime increase | 4.8 | 2.4 | 2.0 | | |

Result 4

*Solution with white* external *light source + WRGB OLED display*

The numerical values are listed in Table 7. The proposed solution allows for an increase in luminance for white of 21% compared to the circular polarizer.

Table 7: Calculations for a WRGB OLED display, a white external light source, and absorbing dyes fabricated by Exciton.

| | | R | G | B | W | W (L) |
|---|---|---|---|---|---|---|
| Polarizer transmission | Polarizer | 0.45 | 0.45 | 0.45 | 0.45 | 0.45 |
| Absorption filter transmission | Amber and cyan filter | 0.82 | 0.57 | 0.60 | 0.59 | 0.54 |
| Transmission ratio | L Increase | +83% | +27% | +33% | +32% | +21% |
| Lifetime increase | Lifetime increase | 4.8 | 1.9 | 2.1 | 2.0 | |

Here follows calculations of embodiments comprising absorbing dyes from Epolight.

Result 5

*Absorbing dyes from Epolight and Exciton.*

*Solution with white* external *light source + side-by-side RGB OLED display*

The numerical values are listed in Table 8. The proposed solution allows for an increase in luminance for white of 60% compared to the circular polarizer.

Table 8: Calculations for an RGB OLED display, a white external light source, and absorbing dyes fabricated by Epolight and Exciton.

| | | R | G | B | W | W (L) |
|---|---|---|---|---|---|---|
| Polarizer transmission | Polarizer | 0.45 | 0.45 | 0.45 | 0.45 | 0.45 |
| Absorption filter transmission | Amber and cyan filter | 0.88 | 0.70 | 0.64 | 0.74 | 0.72 |
| Transmission ratio | L Increase | +97% | +56% | +41% | +64% | +60% |
| Lifetime increase | Lifetime increase | 4.8 | 1.9 | 2.1 | 2.0 | |

Result 6

*Absorbing dye from Epolight and Exciton*

*Solution with white external light source + WRGB OLED display*

The numerical values are listed in Table 9. The proposed solution allows for an increase in luminance for white of 32% compared to the circular polarizer.

Table 9: Calculations for a WRGB OLED display, a white external light source, and absorbing dyes fabricated by Epolin.

|  |  | R | G | B | W | W (L) |
|---|---|---|---|---|---|---|
| Polarizer transmission | Polarizer | 0.45 | 0.45 | 0.45 | 0.45 | 0.45 |
| Absorption filter transmission | Amber and cyan filter | 0.88 | 0.63 | 0.65 | 0.65 | 0.60 |
| Transmission ratio | L Increase | +96% | +41% | +45% | +43% | +32% |
| Lifetime increase | Lifetime increase | 4.8 | 1.9 | 2.1 | 2.0 |  |

Measurements were performed on two different devices.

*Device 1*

Figure 13 shows an embodiment of the present invention comprising a device 118 having two glass plates 110 and 111, with anti-reflective (AR) coatings 112 and 113 respectively. The outward sides of the AR coatings are facing air. An absorbing material 114, e.g. a dye, is placed between the glass plates 110 and 111. A light source 115, e.g. based on OLED technology, provides light 116 onto one side of the device 118. The light is partially absorbed by the device 118 and remaining light exits on the other side as transmitted light 117.

A goal of performing measurements on this device was to measure the fraction of light that passes through the stack. The setup resembles the embodiment of the present invention where the absorbing layer is applied onto the front glass of the display. However, in the experiment there is an air-glass and a glass-air interface which is causing additional reflections, thus the transmission of the filter will be lower than what would be obtained in a final product. The transmitted light was measured by means of a spectrometer. The difference in light output for the absorbing layer and the circular polarizer was also visually evaluated (by eye inspection).

*Device 2*

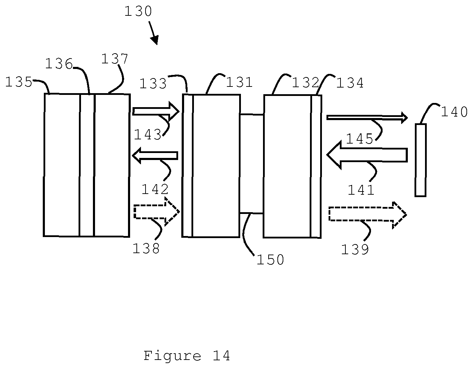

Figure 14 shows an embodiment of the present invention comprising a device 130 having two glass plates 131 and 132, with anti-reflective (AR) coatings 133 and 134 respectively. The outward sides of the AR coatings are facing air. An absorbing material 150, e.g. a dye, is placed between the glass plates 131 and 132. A light source 136, e.g. based on narrowband OLED light, is embedded between a metallic back plate 135, e.g. Aluminium, and a glass plate 137. Note that there is no circular polarizer present in this device. The light source 136 represents the displays internal light source, providing light 138 (for displaying content). The light 138 passes the glass panes 131 and 132 and the absorption layer 150. However, since the absorption layer 150 is designed to let most of the internal light 138 pass undisturbed, the filtered light 139 does not differ much from the initial internal light 138.

An external light source 140 provides ambient light 141, which is transmitted through the glass panes 131 and 132 and the absorption layer 150. Since the absorption layer 150 is designed to absorb as much as possible of the ambient light 141, the filtered light 142 is significantly decreased. The light 142 will be reflected at the metallic back plate 135 and the reflected light 143 can again be filtered by the absorption layer 150, resulting in the filtered light 145. Hence, the internal light 138 is to a large extent preserved while the ambient light 145 can be significantly decreased. A goal of the experiment was to visually observe (by means of spectrometry) the amount of total reflected light is reflected.

*OLEDs*

The devices were built using a WRGB OLED display from an LG OLED55B6V OLED TV and a side-by-side RGB OLED display from a Samsung® Note III.

*Filter*

An absorbing dye (ABS 584 fabricated by Exciton) that absorbs in the amber region of the visible spectrum was used as absorbing layer. The dye was dissolved in an optical adhesive that can be thermally cured. The liquid was kept between two glass plates of 10x20cm by sealing the edges. Spacers of $100\mu$m were used to set the distance between the glass plates.
The optical density of the dye is 190 L/(g*m), aiming for a transmission of approximately 7.5% at the peak absorption wavelength. We find:

```
optical density = -log10(transmission) → 7.5% transmission =
absorbance of 1.125

absorbance [-] = strength [L/(g.cm)] x concentration [g/L] x
pathlength [cm]

→ concentration = absorbance / (strength x pathlength)
          = 1.125 / (190 x 0.01) = 0.592 gram/litre
```

*External light source*

The external light source was implemented using packaged LEDs positioned on heat sinks. Three of these heat sinks were attached to a rectangular metal heat sink by means of thermal paste. This assures that the heat produced by the LEDs is efficiently extracted and prevents excessive temperatures of the LED dye (which could lead the peak emission wavelength of the LEDs to shift).
An interference filter is added in the optical path of the LEDs for further tuning the spectral emission of the LED.

*Measurement results of Device 1*

The luminance of the light that passed through the stack of Device 1 was measured with a spectrometer and compared with measurements of the same OLED light sources implemented in a stack with a conventional polarizer. The side-by-side RGB OLED display and the WRGB OLED display showed an increase in luminance for white of respectively 58% and 34%, see table 10 and 11.

Table 10: Measured increase in light output when using the absorbing layer instead of a circular polarizer on a RGB OLED display

|            | R     | G     | B     | W     | W (L) |
|------------|-------|-------|-------|-------|-------|
| Polarizer  | 0.45  | 0.45  | 0.45  | 0.45  | 0.45  |
| Calculated | 0.88  | 0.78  | 0.98  | 0.87  | 0.78  |
| Measured   | 0.82  | 0.70  | 0.95  | 0.82  | 0.71  |
| L Increase | +82%  | +55%  | +111% | +82%  | +58%  |

Table 11: Measured increase in light output when using the absorbing layer instead of a circular polarizer on a WRGB OLED display

|            | R     | G     | B     | W     | W (L) |
|------------|-------|-------|-------|-------|-------|
| Polarizer  | 0.45  | 0.45  | 0.45  | 0.45  | 0.45  |
| Measured   | 0.87  | 0.71  | 0.96  | 0.79  | 0.57  |
| L Increase | +93%  | +57%  | +114% | +76%  | +34%  |

Visual evaluation (by spectrometry) confirmed a significant increase in light output of a side-by-side RGB and a WRGB OLED display when using the present invention instead of a circular polarizer.

*Measurement results of Device 2*

In the second experiment the reflection of ambient light by the OLED display having a circular polarizer was compared to the reflection of the OLED display also having an absorbing layer, when the ambient light had a selected narrowband emission. The amount of reflection was visually compared (by eye inspection) for both solutions. The visual comparison indicated a similar reflection for both solutions.

*Tuning the white point*

Adding the absorbing layer on top of a fixed format display such as an OLED display causes some absorption of the display's internally emitted light. The absorption is not the same for all wavelengths, which causes a shift in color point that needs to be compensated for. The light intensity for each pixel of a display can be controlled through the Digital Driving Level, DDL, a value between 0 and 255. If a color is absorbed it is ideally desired to increase the driving intensity for that color. However, since there are no DDLs higher than 255, this method would not work for levels already at 255, hence, the method would not yield a uniform result. Therefore the DDLs for the colors that are not absorbed are instead decreased. In this section, it will be determined what driving is needed to restore the color point for white, red, green and blue to its original value. Also it is determined what increase in light output is left after changing the driving level. Table 12 shows the gain in light output for the absorber compared to the polarizer after the white point has been restored.

Table 12: Measured increase in light output when using the absorbing layer instead of a circular polarizer on a WRGB OLED display, after correcting for the shift in light output.

|  | R | G | B | W | W (L) |
|---|---|---|---|---|---|
|  | (255,25,0) | (0,255,0) | (0,0,255) | (255,249,197) | (255,249,197) |
| Ratio of light output for the absorber and the polarizer | +101% | +65% | +125% | +58% | +44% |

Color management or color calibration can be the act of adapting the display performance so that a certain input gives a required output. This may comprise to work within a standard gamut (e.g. sRGB) or to remap a wide color gamut on a smaller gamut with less saturated colors. The procedure can take into account any expected limiting effects, such as e.g. from an absorbing layer in the display, and assures all color points of the color space remain accessible. The present invention also provides a method for adjusting a color point shift of the internal light sources to the initial color points of internal light sources, the method comprising the step of reducing the DDLs of the internal light sources having color points in a color space such that the initial color points of the combined light are preserved in the color space and the driving level of any light source is 255 or less.

*Further embodiments*

The present invention can comprise, for example a film containing one or more absorbing dyes for absorbing the ambient light impinging and reflecting on the fixed format display such as the OLED display. The absorption intensity is a function of the path length of the light travelling through the display. Light that travels through the absorbing layer perpendicular to the layer surface will have the shortest path length while light that travels through the layer under an angle will have a longer path length. Therefore, the absorption of the light emitted by the fixed format display such as the OLED display will be different depending on the angle under which the display is being viewed. Therefore a solution could comprise adding a scattering layer after the absorbing layer, so that the internal light which becomes angular dependent after passing the absorbing layer gets smoothed out. The scattering layer will average out the angular variation of the light.

*Optimized AR coating*

If the front surface of the display can be glass that resides in air, ambient light impinging on the display will reflect at the interface due to the difference in refractive index between glass and air. The magnitude of this reflection is approximately 4%. For conventional displays, an AR coating is added on top of the front glass to reduce reflection. This AR coating is often designed for a wide wavelength region, because ambient light, like daylight or conventional indoor lighting, typically contains a broad range of wavelengths. As the eye is most sensitive to green, the AR coating is often designed to have highest efficiency in the green wavelength range. In designing an AR coating it is typically necessary to make a trade-off between the coverage of a broad wavelength range and the magnitude of the decrease. Since embodiments of the present invention can be implemented with narrow band ambient light, it is possible to optimize the AR coating for these specific wavelength bands so that the reflection can be further decreased.

In a first aspect, the present invention also provides a method for reducing the reflection of external light in a display system comprising a display with internal emissive light sources and a layer for light absorption, at least one external light source, the internal light sources providing internal light with spectral emission bands, and at least one external light source providing external light of at least one spectral emission band, the absorption layer having at least one spectral absorption band and at least one spectral transmission band, the method comprising the steps of the external light source being selected so that the wavelength range within the full width half maximum of each of the at least one external spectral emission band is not overlapping with the wavelength range within the full width half maximum of any of the spectral emission bands of the internal light, and absorption layer being selected such that each of the at least one spectral emission band of the external light is overlapped by a spectral absorption band of the absorption layer such that the absorption of the external light is at least 50%, 60, 70 % or up to 80% or equivalent and the spectral emission bands of the internal light sources are overlapped by a spectral transmission band of the absorption layer such that the transmission of each of the internal light is at least 45%, 55% or 65% up to 75% or equivalent.

In a second aspect according to the first aspect, the absorption layer is selected such that each of the at least one spectral emission band of the external light is overlapped by a spectral absorption band of the absorption layer such that the absorption of the external light is at least 60, 70 or up to 80% or equivalent.

In a third aspect according to any of the first or second aspect, the spectral emission bands of the internal light sources are overlapped by a spectral transmission band of the absorption layer such that the transmission of each of the internal light is at least 55%, 65%, or up to 75% or equivalent.

In a fourth aspect according to any of the first to the seventeenth aspect, each of a multiple of external light sources contributes light so that all of the light sources together provide white light.

In a fifth aspect according to any of the first to the fourth aspect, the method further comprises providing an anti-reflective coating to reduce reflection in the spectral emission bands of the external light.

In a sixth aspect according to any of the first to the fifth aspect, the method further comprises the step of providing an anti-reflective coating to enhance transmission in the spectral emission bands of the internal light, or optionally primarily in the spectral emission bands of the internal light.

In a seventh aspect according to any of the first to the sixth aspect, the method further comprises the step of positioning a light scattering layer to receive internal light transmitted by the absorption layer.

In an eighth aspect according to any of the first to the seventh aspect, the method further comprises the step of having a first, second and third internal light source, each emitting at least 80% of the total energy of its light emission in the wavelength range 440 nm - 481 nm, 503 nm - 569 nm and 588 nm - 664 nm, respectively.

In a ninth aspect according to any of the first to the eighth aspect, the method further comprises the step of having a first, second and third internal light source, and a light absorption layer, whereby the intensities of the first, second and third internal light sources are tuned such that the light transmitted by the absorption layer is white light.

In a tenth aspect according to any of the first to the ninth aspect, the method further comprises the step of using one external light source emitting at least 80% of the total energy of its light emission in the wavelength range 482 nm - 502 nm or 570 nm - 587 nm.

In an eleventh aspect according to any of the first to the tenth aspect, the method further comprises the step of using a first and a second external light source, each emitting at least 80% of the total energy of its light in the wavelength range 482 nm - 502 nm and 570 nm - 587 nm, respectively.

In a twelfth aspect according to any of the first to the eleventh aspect, at least 80% of the external light in said wavelength range is absorbed by the absorbing layer in the wavelength range 482 nm - 502 nm or 570 nm - 587 nm.

In a thirteenth aspect according to any of the first to the twelfth aspect, the absorption layer transmits in wavelength ranges 440 nm - 481 nm, 503 nm - 569 nm and 588 nm - 664 nm such that at least 50% of the light of each of the internal light sources in said wavelength ranges is transmitted.

In a fourteenth aspect according to any of the first to the thirteenth aspect, the method further comprises the step of embedding the external light source on the front side and/or back side of the display housing, or placed separately from the display housing.

In a fifteenth aspect according to any of the first to the fourteenth aspect the method further comprises the step of positioning the layer for light absorption in between the internal light sources of the display and the front of the display, or between the internal light sources of the display and the front glass of the display.

In a sixteenth aspect according to any of the first to the fifteenth aspect, the method further comprises the step of bonding the front to the display using the layer for light absorption.

While the invention has been described hereinabove with reference to specific embodiments, this was done to clarify and not to limit the invention. The skilled person will appreciate that various modifications and different combinations of disclosed features are possible without departing from the scope of the invention.

**Claims**

1. A display system comprising

   - a display with internal emissive light sources and with a light absorption layer, wherein internal light from the internal emissive light sources has spectral emission bands and wherein the light absorption layer has at least one spectral absorption band and at least one spectral transmission band,
   - at least one external light source, wherein the external light from the at least one external light source has at least one external spectral emission band,

   **characterized in that**

   - the external light source is selected so that the wavelength range within the full width half maximum of each of the at least one external spectral emission band has no overlap with the wavelength range within the full width half maximum of any of the spectral emission bands of the internal light, and
   - the absorption layer is selected and positioned such that each of the at least one external spectral emission band of the external light is overlapped by a spectral absorption band of the absorption layer such that the absorption of the external light is at least 50%, and
   - the spectral emission bands of the internal light sources are overlapped by a spectral transmission band of the absorption layer such that the transmission of the light of each of the internal light sources is at least 45%.

2. Display system according to claim 1, wherein the absorption layer is selected such that each of the at least one spectral emission band of the external light is overlapped by a spectral absorption band of the absorption layer such that the absorption of the external light is at least 60, 70 or up to 80% or equivalent.

3. Display system according to claim 1 or 2, wherein the spectral emission bands of the internal light sources are overlapped by a spectral transmission band of the absorption layer such that the transmission of each of the internal light is at least 55%, 65%, or up to 75% or equivalent.

4. Display system according to any of claims 1 to 3, wherein the contribution of each of a multiple of external light sources is adapted so that all of the light sources together provide white light.

5. Display system according to any of claims 1 to 4, comprising an anti-reflective coating which is configured to reduce reflection in the spectral emission bands of the external light.

6. Display system according to any of claims 1 to 5, comprising an anti-reflective coating which is configured to enhance transmission in the spectral emission bands of the internal light, or optionally primarily in the spectral emission bands of the internal light.

7. Display system according to any of claims 1 to 6, comprising a light scattering layer positioned to receive internal light transmitted by the absorption layer.

8. Display system according to any of claims 1 to 7, wherein the internal emissive light sources comprise a first, second and third internal light source, each emitting at least 80% of the total energy of its light emission in the wavelength range 440 nm - 481 nm, 503 nm - 569 nm and 588 nm - 664 nm, respectively.

9. Display system according to any of claims 1 to 8, wherein the internal emissive light sources comprise a first, second and third internal light source, wherein the intensity of the first, second and third internal light sources are tuned such that the light transmitted by the absorption layer is white light.

10. Display system according to any of claims 1 to 9, wherein at least one of the external light source is configured to emit at least 80% of the total energy of its light emission in the wavelength range 482 nm - 502 nm or 570 nm - 587 nm or wherein the external light source comprises a first and a second external light source, each emitting at least 80% of the total energy of its light in the wavelength range 482 nm - 502 nm and 570 nm - 587 nm, respectively.

11. Display system according to any of claims 1 to 10, wherein at least one of the absorption of the absorption layer in the wavelength range 482 nm - 502 nm or 570 nm - 587 nm is such that at least 80% of the external light in said wavelength range is absorbed or the transmission of the absorption layer in wavelength ranges 440 nm - 481 nm, 503 nm -569 nm and 588 nm - 664 nm is such that at least 50% of the light of each of the internal light sources in said wavelength ranges is transmitted.

12. Display system according to any of claims 1 to 11, wherein the external light source is embedded on the front side and/or back side of the display housing, or placed separately from the display housing.

13. Display system according to any of claims 1 to 12, wherein the layer for light absorption is positioned in between the internal light sources of the display and the front of the display, or between the internal light sources of the display and a front glass of the display.

14. Display system according to any of claims 1 to 13, wherein the layer for light absorption also serves as a bonding layer for bonding the front to the display.

15. A method for reducing the reflection of external light in a display system, the method comprising the steps of

   - providing a display with internal emissive light sources and an absorption layer, wherein internal light from the internal emissive light sources has spectral emission bands and the absorption layer has at least one spectral absorption band and at least one spectral transmission band,
   - providing at least one external light source, wherein the external light from the at least one external light source has at least one external spectral emission band,

   **characterized in that**

   - the external light source is selected so that the wavelength range within the full width half maximum of each of the at least one external spectral emission band has no overlap with the wavelength range within the full width half maximum of any of the spectral emission bands of the internal light, and
   - the absorption layer is selected and positioned such that each of the at least one external spectral emission band of the external light is overlapped by a spectral absorption band of the absorption layer such that the absorption of the external light is at least 50%, and
   - the spectral emission bands of the internal light sources are overlapped by a spectral transmission band of the absorption layer such that the transmission of the light of each of the internal light sources is at least 45%.

a)

b)

Figure 1

Figure 2

Figure 3

Figure 4

Figure 5

Figure 6

Figure 7

Figure 8

Figure 9

Figure 10

Figure 11

Figure 12

Figure 13

Figure 14

Europäisches
Patentamt

European
Patent Office

Office européen
des brevets

# EUROPEAN SEARCH REPORT

**Application Number**

EP 18 18 6388

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2007/052341 A1 (IMAFUKU DAISUKE [JP] ET AL) 8 March 2007 (2007-03-08)<br>* paragraphs [0005], [0007], [0008], [0009], [0019], [0020], [0027], [0028], [0031], [0032]; claim 12; figures 2,3,5 * | 1-9,<br>11-15<br>10 | INV.<br>H01L51/52 |
| A | JP 2011 075738 A (CASIO COMPUTER CO LTD) 14 April 2011 (2011-04-14)<br>* paragraphs [0007], [0008], [0009], [0013] - [0016], [0018]; figures 1,3,4,5 * | 1-15 | |

**TECHNICAL FIELDS SEARCHED (IPC)**

H01L
G02F

The present search report has been drawn up for all claims

| Place of search | Date of completion of the search | Examiner |
|---|---|---|
| The Hague | 10 January 2019 | Faou, Marylène |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 18 18 6388

This annex lists the patent family members relating to the patent documents cited in the above-mentioned European search report.
The members are as contained in the European Patent Office EDP file on
The European Patent Office is in no way liable for these particulars which are merely given for the purpose of information.

10-01-2019

| Patent document cited in search report | Publication date | Patent family member(s) | Publication date |
|---|---|---|---|
| US 2007052341 A1 | 08-03-2007 | CN 1924692 A<br>JP 2007065520 A<br>US 2007052341 A1 | 07-03-2007<br>15-03-2007<br>08-03-2007 |
| JP 2011075738 A | 14-04-2011 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7259505 B2
- US 6936960 B2

- US 9142803 B